# EUROPEAN PATENT SPECIFICATION

(11) **EP 0 292 295 B1**
(45) Date of publication and mention of the grant of the patent: **27.01.1993**
(21) Application number: 88304561.9
(22) Date of filing: 19.05.1988
(51) Int. Cl.: B23K 20/00, H01L 21/607

(54) **Bumpless tape automated bonding**
Automatisches Filmträgerbonden ohne Höcker
Soudure automatique de bandes sans bossage

(30) Priority: 20.05.1987 US 52666
(43) Date of publication of application: 23.11.1988
(73) Proprietor: Hewlett-Packard Company, Palo Alto, California 94304 (US)
(72) Inventor: Pollacek, James, Corvallis Oregon 97330 (US)
(74) Representative: Williams, John Francis

(56) References cited:
- EP-A- 0 130 498
- EP-A- 0 154 578
- US-A- 4 490 728
- IBM TECHNICAL DISCLOSURE BULLETIN. vol. 25, no. 4, 01 September 1982, NEW YORK US pages 1948 - 1949; J. C. EDWARDS: "No-bump beam tape"
- idem

## Description

The present invention relates to a tape automated bonding (TAB) method according to the preamble of claim 1. Such a method is known from IBM Technical Disclosure Bulletin, Vol. 25, No. 4, September 1982, pages 1948-1949.

### 2. Description of the Related Art

In the manufacture of electronic devices (for example, thin-film structures such as for thermal ink-jet resistor array devices or semiconductor integrated circuits (IC), it has become feasible to make a large number of metallic interconnections to microscopic pads on the structure by utilizing a roll-type, metal film cut to form an individual set of leads, commonly known as "beam tape." The beam tape can be patterned in customized sections to match the interconnections required for the particular application. At an automated bonding station, the beam tape and structure are brought together by various known processes to connect the leads to the structure.

Generally, a precision ground thermode applies heat and pressure to the metal beams and underlying, raised, interconnection weld-spot bumps (known as "bonding pads") which lie generally atop the structure to be connected. Both high temperature thermocompression welding and lower temperature, lower pressure solder reflow welding are known, particularly for "gang-bonding" (where all welds are made simultaneously on the structure). Individual circuits may be bonded to inner leads of the beam tape and then tested while still in continuous tape form.

Two-layer beam tape is fabricated with a polyimide film to facilitate the bonding process where it is desirable to have such a dielectric barrier between the lead traces and the structure to be interconnected.

A known, typical technique is described in U.S. Patent No: 4, 551, 912 (Marks, et al). In that patent, a method of forming semiconductor chips is shown wherein a continuous sheet TAB material is moved to a cutting station. By computer control, a laser forms a "footprint" (pattern for the device to be attached), the material is moved to a bonding station where it is aligned with the chip, and a computer controlled bonding tool (an ultrasonic probe) sequentially bonds each lead in the pattern to a corresponding bump (raised interconnection weld spot) previously fabricated into the chip structure.

Typical bump height is 25.4 to 38.1 microns (1.0 to 1.5 mils) above the die major surface. Alternatively, prebumped beams are provided by beam tape manufacturers. A difficulty with the Marks, et al. system is the requirement of the bumps.

Basically, this technique is used to prevent short circuits from occurring between the lead and the peripheral edge of the semiconductor material of the substrate. In addition to IC fabrication process difficulties and expenses added to the chips to include the bonding bumps, in other technologies, such as a thin-film structure for an ink-jet printhead, topology requirements may severely limit or even prohibit the inclusion of bumps.

Moreover, heat bonding, such as by laser or thermode probes, may be inapplicable to structures not designed by withstand high temperature excursions.

Hence, there is a need for a heatless and bumpless TAB technique.

A further known technique is described in IBM Technical Disclosure Bulletin, Vol. 25, No. 4, September 1982 which discloses a tape automated bonding method for a thin film structure, having a substrate, a contact region in a surface of said substrate, and at least one passivation layer superposing said surface, comprising the steps of; forming a via in said passivation layer to an area of said contact region, superposing a conductive tape beam across said via, and fixing said beam in said via.

However, in this technique bonding can only be achieved close to the edge of the substrate.

Accordingly, the invention provides a tape automated bonding method as defined in claim 1.

It is an advantage of the present invention that it provides a heatless TAB process.

Another advantage of the present invention is that it eliminates the need for bonding bumps on the structure to be TAB interconnected, thus improving both yield and cost per wafer.

A further advantage of the present invention is that it provides a TAB process which can be used to form connections on places of the structure other than the periphery.

Yet a further advantage of the present invention is that it allows the structure to be placed in a package before bonding.

Still another advantage is that the present invention allows the forming of jumper interconnects between different sections of the structure.

Other objects, features and advantages of the present invention will become apparent upon consideration of the following detailed description and the accompanying drawings, in which like reference designations represent like features throughout the FIGURES. The description is of an exemplary embodiment of the invention.

### BRIEF DESCRIPTION OF THE DRAWINGS

Figure 1 is a cross-sectional drawing of the present invention structure in position for bonding taken in plane A-A of Figure 2.

Figure 2 is a plan view (top) showing two trace beams in position for bonding in accordance with the present invention.

Figure 3 is a plan view (top) showing an interconnect layout for a thin-film structure in accordance with the present invention.

The drawings referred to in this description should be understood as not being drawn to scale.

### DETAILED DESCRIPTION OF THE INVENTION

It should be recognized that many publications describe the details of common techniques used in the fabrication processes of integrated circuit components and other thin film devices. See, e.g., Ghandi, S.K., VLSI Fabrication Principles, copyright 1983, John Wiley & Sons, or Semiconductor & Integrated Circuit Fabrication Techniques, Reston Publishing Co., Inc., copyright 1979 by the Fairchild Corporation. Those techniques can be generally employed in the fabrication of the structure of the present invention. Moreover, the individual steps of such a process can be performed using commercially available integrated circuit fabrication machines. As specifically helpful to an understanding of the present invention, approximate technical data are set forth based upon current technology.
Future developments in this art may call for appropriate adjustments as would be obvious to one skilled in the art.

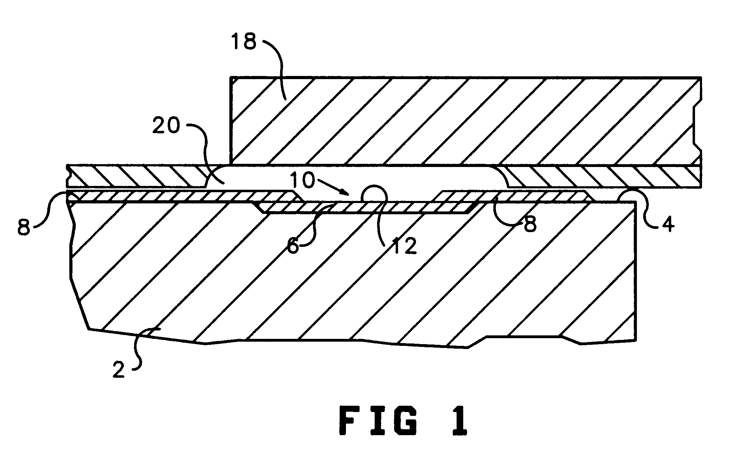

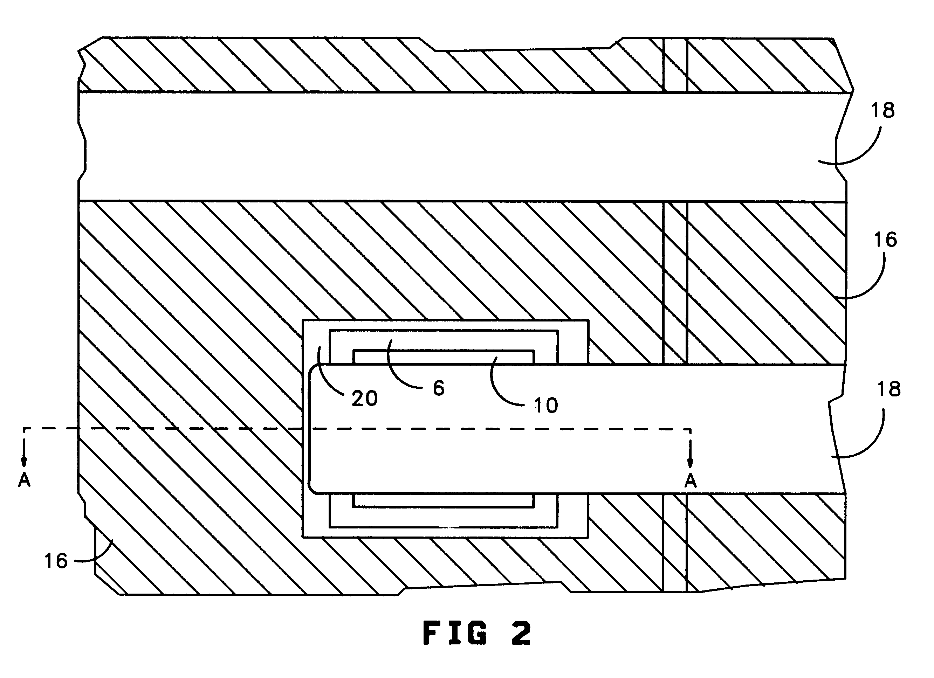

Referring now to FIGURE 1, a structure formed in accordance with the present invention is shown in cross-section (taken in plane A-A as shown in FIGURE 2). As will be apparent to a person skilled in the art, the depiction is only intended to be of a small section of an entire device, such as an edge of an integrated circuit chip.

A substrate 2, such as silicon IC die, has a first surface 4. A bonding pad 6 is formed in or on the substrate surface 4. The pad 6 may be formed by any one of the known techniques such as metal deposition and etching to desired geometry. For the purpose of the present invention, the pad 6 should be formed of aluminum to a thickness in the range of 0.3 to 1.0 micron. In the preferred embodiment, the thickness is approximately 0.5 micron.

A passivation layer 8 is formed on substrate surface 4. Many well-known materials, such as silicon dioxide, silicon nitride, silicon oxynitride, and silicon carbide, or combinations thereof, can be used to form the passivation layer 8. The passivation layer 8 should have a thickness in the range of 0.5 to 3.0 microns. In the preferred embodiment, the thickness is approximately 1.38 microns, comprising a combination of silicon nitride and silicon carbide. In the preferred embodiment, the passivation layer 8 comprises a three-stack layer where the bottom layer is silicon nitride which is 0.52 micron thick; the middle layer is formed of silicon carbide which is 0.26 micron thick; and the top layer is tantalum, which is 0.6 micron thick.

An aperture, or via, 10 is etched to expose at least a portion of the surface 12 of pad 6. Again, there are several well-known techniques for forming such a via 10. In the preferred embodiment, via 10 is formed by wet-etch for the tantalum and a plasma dry-etch for the middle and bottom layers.

In the preferred embodiment, the aperture 10 has an area of approximately 2.6 mm square (0.0040 inch square).

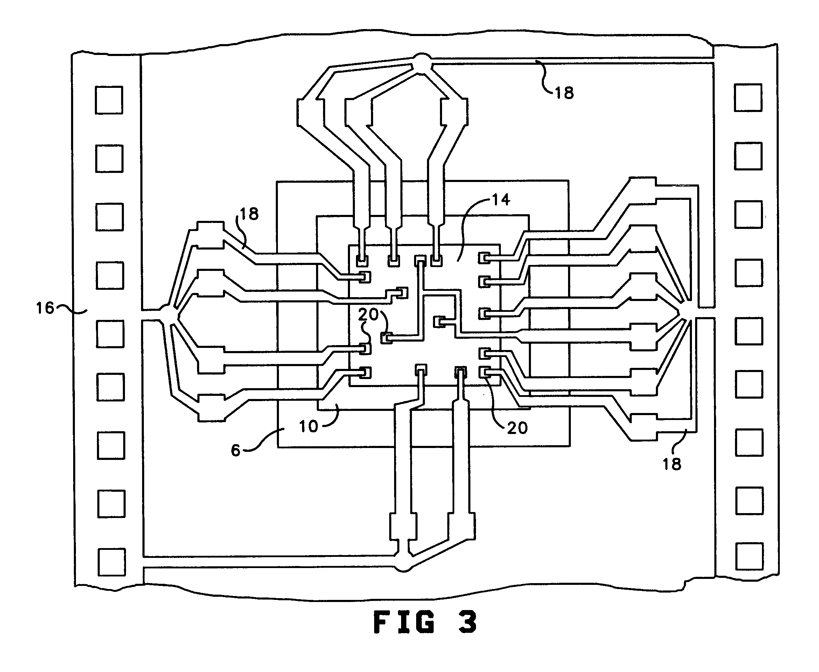

Referring briefly to Figure 3, an entire chip is encased in a polymide tape 16. The polyimide has a thickness of approximately 12.7 micron (0.0005 inch). In accordance with a predetermined pattern matching the pattern of the bonding pads 6 on the structure to be interconnected, vias 20 are etched in the polyimide. While there are several known techniques for forming the pattern of polyimide vias 20, in the preferred embodiment, common chemical milling is used.

As shown in Figure 1, the polyimide vias 20 are greater in area than passivation layer vias 10 in order to allow room for the beam being attached and registration misalignments. In the preferred embodiment, the aperture 20 has an area of approximately 3.9 mm square (0.0060 inch square).

Predesigned and interconnect leads 18 formed in a beam tape strip on a polyimide layer having said apertures 20 can be aligned with the structure to be bonded at a bonding station.

The conductive tape beam is placed across a via, and a first force s applied to said beam to deform it into said via and into contact with said contact region. Simultaneously, a second force is applied to said beam to bond said beam to said contact region.

In the preferred embodiment, the traces are 28.3g (1 ounce) 35.6 micron (0.0014 inch) copper traces that have a hardness of approximately 60 to 100 Knoop, which have been chemically milled to the desired pattern. Beam widths and spaces in the range of approximately 65 to 75 micrometers (0.0025 to 0.0030 inches) can be achieved with currently known chemical milling techniques. The copper traces are plated to a thickness of 0.77 microns (30 microinches) with 99.99% pure gold.

Once the copper trace beam tape is properly aligned to the structure, a commercial bonding machine, such as a Hughes Aircraft 2460-2 wirebonder is used to attach the trace leads 18 to the pads through the vias 10 and 12. In the preferred embodiment, approximately 130 grams force is applied for about 50 milliseconds with approximately 3,3 micrometers (130 microinches) of about 60 kHz ultrasonic scrub. These bonding parameters yield a mean pull strength of approximately 40 grams with a standard deviation of about 4.0 grams. a range of about 100 to 140 grams for 30 to 80 milliseconds with 2.5 to 3.8 micrometers (100 to 150 microinches) of 60 kHz scrub will suffice to provide a proper connection.

In the best mode for practising the TAB process described, single point TAB techniques are applicable.

A major advantage of the present invention as shown in Figure 3 is that pads can be located anywhere on the device since topology remains as close to planar as possible.

## Claims

1. A tape automated bonding method for connecting a conductive tape beam (18) to a contact region (6) formed on a substrate (2) of a thin film structure without the placement of bonding pad bumps on either the tape beam or the contact region, the contact region (6) being formed in a surface (4) of said substrate, and at least one passivation layer (8) superposing said surface, comprising the steps of: forming a via (10) in said passivation layer to an area of said contact region; superposing a conductive tape beam (18) across said via, and fixing said beam in said via, wherein a first force is applied to said beam to deform said beam into said via and into contact with said contact region, the method being characterised in that ultrasonic scrub is applied to said beam to bond said beam (18) to said contact region (6).

2. A method according to claim 1, wherein the conductive tape beam (18) includes a conductive layer (18) and a support layer (16), the support layer having a support layer via corresponding in position to the via (10) in the passivation layer (8).

3. A method according to claim 1 or 2, wherein the first force and the ultrasonic scrub are applied to the beam simultaneously.

4. A method according to any preceding claim, wherein said step of applying said first force comprises: applying approximately 100 to 140 grams linearly for 30 to 80 milliseconds.

5. A method according to any preceding claim, wherein said ultrasonic scrub has is applied with about 2.5 to 3.8 micrometres (100 to 150 microinches) of 60 kHz scrub.

6. A method according to any preceding claim, wherein the conductive layer (18) is formed of copper having a thickness of about 36 micrometres (0.0014 inches) and a hardness of about 60 to 100 knoop, that is plated with 99.99% gold to a thickness of about 0.7 micrometres (30 microinches).

7. A method according to any preceding claim, wherein the thin film structure is chemically milled to a predetermined pattern, such that each beam (18) has a width of about 65 to 75 micrometres (0/0025 to 0.003 inches).

8. A method according to any preceding claim, wherein said via (10) and said contact region (6) are formed at a position other than the periphery of said thin film structure.

## Patentansprüche

1. Verfahren zum automatischen Filmträgerbonden zum Verbinden eines leitenden Filmbaumes (18) mit einem Kontaktgebiet (6) auf einem Substrat (2) einer Dünnfilm-Struktur ohne Plazieren von Hafthöckern auf dem Filmbaum oder im Kontaktgebiet, wobei das Kontaktgebiet (6) in einer Oberfläche (4) des Substrates ausgebildet ist und mindestens eine Passivierungsschicht (8) diese Oberfläche überlagert, mit den folgenden Schritten: Bilden einer Bahn (10) in der Passivierungsschicht zu einem Bereich des Kontaktgebietes; Überlagern eines leitenden Filmbaumes (18) quer über die genannte Bahn und Fixieren des Baumes in der Bahn, wobei eine erste Kraft auf den Baum zu dessen Hineinverformen in die Bahn und in Berührung mit dem Kontaktgebiet aufgebracht wird, dadurch gekennzeichnet, daß der Baum einer Ultraschallbehandlung unterzogen wird, um den Baum (18) an das Kontaktgebiet (6) anzubonden.

2. Verfahren nach Anspruch 1, bei dem der leitende Filmbaum (18) eine leitende Schicht (18) und eine Stützschicht (16) umfaßt, wobei die Stützschicht eine Stützschichtbahn aufweist, deren Position der Bahn (10) in der Passivierungsschicht (8) entspricht.

3. Verfahren nach Anspruch 1 oder 2, bei dem die erste Kraft und die Ultraschallbehandlung gleichzeitig auf den Baum ausgeübt werden.

4. Verfahren nach einem der vorangehenden Ansprüche, bei dem das Aufbringen der ersten Kraft umfaßt: lineares Aufbringen von etwa 100-140 g 30-80 ms lang.

5. Verfahren nach einem der vorangehenden Ansprüche, bei dem die Ultraschallbehandlung mit 2,5 - 3,8 µm (100-150 µinch) bei einer Frequenz von 60 kHz angewendet wird.

6. Verfahren nach einem der vorangehenden Ansprüche, bei dem die leitende Schicht (18) aus Kupfer einer Dicke von 36 µm (0,0014 inch) mit einer Härte von 60 bis 100 knoop geformt und mit 99,99 % Gold einer Stärke von etwa 0,7 µm (30 µinch) plattiert ist.

7. Verfahren nach einem der vorangehenden Ansprüche, bei dem die Dünnfilm-Struktur chemisch auf ein vorbestimmtes Muster bearbeitet ist derart, daß jeder Baum (18) eine Breite von etwa 65-75 µm (0,0025-0,003 inch) hat.

8. Verfahren nach einem der vorangehenden Ansprüche, bei dem die Bahn (10) und das Kontaktgebiet (6) an einer anderen Stelle als am Umfang der Dünnfilm-Struktur ausgebildet ist.

## Revendications

1. Un procédé de liaison automatique de bande pour relier un faisceau (18) sur bande conductrice à une région de contact (6) formée sur un substrat (2) d'une structure à film mince sans avoir à disposer des bossages de liaison soit sur le faisceau soit sur la région de contact, cette région de contact (6) étant formée dans une surface (4) dudit substrat, et au moins une couche de passivation (8) disposée sur ladite surface, procédé comprenant les étapes consistant à : former un passage de traversée (10) dans ladite couche de passivation jusqu'à une zone de ladite région de contact ; superposer un faisceau (18) avec bande conductrice transversalement audit passage de traversée, et fixer ledit faisceau dans ledit passage de traversée, procédé dans lequel une première force est exercée sur ledit faisceau pour le déformer dans ledit passage de traversée et l'amener au contact de ladite région de contact, procédé caractérisé en ce qu'un frottement ultrasonique est exercé sur ledit faisceau pour lier ledit faisceau (18) à ladite région de contact (6).

2. Un procédé selon la revendication 1, dans lequel le faisceau (18) avec bande conductrice comprend une couche conductrice (18) et une couche de support (16), la couche de support comportant un passage de traversée de cette couche de support, situé dans une position correspondant au passage de traversée (10) formé dans la couche de passivation (8).

3. Un procédé selon la revendication 1 ou 2, dans lequel la première force et le frottement ultrasonique sont exercés simultanément sur le faisceau.

4. Un procédé selon une quelconque des revendications précédentes, caractérisé en ce que ladite étape d'application de ladite première force consiste en une application d'une force approximativement de 100 à 140 grammes linéairement pendant 30 à 80 millisecondes.

5. Un procédé selon une quelconque des revendications précédentes, dans lequel ledit frottement ultrasonique est produit sur environ 2,5 à 3,5 microns (100 à 150 micropouces) avec une fréquence de 60 kHz.

6. Un procédé selon une quelconque des revendications précédentes, dans lequel la couche conductrice (18) est formée de cuivre ayant une épaisseur d'environ 36 microns (0,0014 pouce) et une dureté d'environ 60 à 100 unités Knoop, cette couche étant revêtue d'or à 99,99 % de pureté sur une épaisseur d'environ 0,7 micron (30 micropouces ).

7. Un procédé selon une quelconque des revendications précédentes, dans lequel la structure à film mince est érodée chimiquement à une configuration prédéterminée de telle sorte que chaque faisceau (18) ait une largeur d'environ 65 à 75 microns ( 0,0025 à 0,003 pouce).

8. Un procédé selon une quelconque des revendications précédentes, dans lequel ledit passage de traversée (10) et ladite région de contact (6) sont formés dans une position autre que la périphérie de ladite structure à film mince.
